# EUROPÄISCHE PATENTSCHRIFT

(11) **EP 2 815 439 B1**
(45) Veröffentlichungstag und Bekanntmachung des Hinweises auf die Patenterteilung: **22.04.2020**
(21) Anmeldenummer: 13705413.6
(22) Anmeldetag: 07.02.2013
(51) Int. Cl.: H01L 33/60, H01L 33/64, H05K 1/02, H01L 23/00

(54) **LED-Modul mit hoch-reflektivem Träger und Verfahren zum Herstellen eines LED-Moduls mit hoch-reflektivem Träger**
LED module with highly reflective support and method of manufacturing LED module with highly reflective support
Module à DEL avec un substrat de haut reflectivité et procédé de fabrication d'un module à DEL avec un substrat de haut reflectivité

(30) Priorität: 13.02.2012 DE 102012202089; 27.04.2012 AT 1862012 U; 13.12.2012 DE 202012011948 U; 13.12.2012 DE 102012223039
(43) Veröffentlichungstag der Anmeldung: 24.12.2014
(73) Patentinhaber: Tridonic GmbH & Co. KG, 6850 Dornbirn (AT)
(72) Erfinder: WIMMER, Florian, 8380 Neumarkt a.d. Raab (AT); PACHLER, Peter, A-8042 Graz (AT); REITINGER, Norbert, AT-8054 Seiersberg (AT); GUMHOLD, Jürgen, A-8380 Jennersdorf (AT)
(74) Vertreter: Rupp, Christian
(86) Internationale Anmeldenummer: PCT/EP2013/052435
(87) Internationale Veröffentlichungsnummer: WO 2013/120760

(56) Entgegenhaltungen:
- EP-A1- 2 160 082
- EP-A1- 2 387 083
- EP-A2- 2 384 100
- EP-A2- 2 403 324
- WO-A1-2011/097393
- WO-A1-2011/125346
- WO-A1-2011/136446
- DE-A1-102010 011 604
- US-A1- 2007 290 328
- US-A1- 2009 315 057
- US-A1- 2010 193 825
- US-A1- 2011 121 326
- US-A1- 2012 002 420

## Beschreibung

Die vorliegende Erfindung betrifft ein LED-Modul mit einem Träger und wenigstens einem LED-Chip und ein Verfahren zum Herstellen eines solchen LED-Moduls.

Aus dem Stand der Technik sind LED-Module der eingangs genannten Art bekannt. So zeigt bspw. die US 2011/0248287 A1 ein LED-Modul mit einem hochreflektiven Träger. Dazu ist der Träger in Bereichen, in denen keine LED-Chips vorliegen, mit einer reflektierenden Schicht oder Beschichtung versehen. Da die reflektierende Schicht nicht das gesamte Licht reflektiert, kommt es zu einer Verringerung des Wirkungsgrades des Moduls.

Ferner zeigt die US 2011/0001148 A1 ein LED-Modul mit mehreren Schichten, wobei LED-Chips mittels eines thermisch leitenden Klebers auf eine elektrisch isolierende Schicht aufgesetzt werden, welche wiederum auf einem Träger vorgesehen ist. Die LED-Chips werden elektrisch kontaktiert und anschließend mit einer Schicht aus einem hochreflektierenden Material versehen. Darüber werden anschließend eine Streuschicht sowie eine Leuchtstoffschicht aufgebracht. Nachteilig sind hier zum einen der Reflexionsgrad der reflektierenden Schicht, sowie zum anderen der komplexe Aufbau des Moduls.

EP 2 387 083 A1 offenbart ein LED-Modul mit einem hochreflektiven Substrat, wobei eine Reflexionsschicht aus Silber auf einem Teil des Substrathauptkörpers gebildet ist. Die Silberschicht ist von einer ersten und einer zweiten Schutzschicht bedeckt, wovon die zweite Schutzschicht einen keramischen Füllstoff enthält.

Es ist somit eine Aufgabe der Erfindung, ein einfaches LED-Modul sowie als auch ein Verfahren zum Herstellen eines solchen LED-Moduls bereitzustellen, welches einen hohen Reflexionsgrad des Trägers ermöglicht und gleichzeitig eine verbesserte Wärmeabfuhr aufweist.

Diese Aufgabe wird durch die Merkmale der unabhängigen Ansprüche gelöst. Die abhängigen Ansprüche bilden den zentralen Gedanken der Erfindung in besonders vorteilhafter Weise weiter.

Gemäß einem ersten Aspekt der Erfindung wird ein LED-Modul vorgeschlagen, welches einen Träger aufweist, z.B. eine Leiterplatte, wobei auf dem Träger eine metallische Schicht aufgebracht ist. Das LED-Modul weist wenigstens einen LED-Chip sowie eine die metallische Schicht wenigstens teilweise überdeckende, auf dem Träger aufgebrachte Lackschicht, beispielsweise aus einem keramischen Lack auf. Der LED-Chip (oder die SMD-LED) kann bspw. auf der Leiterplatte bzw. der metallischen Schicht (oder der Lackschicht) gemäss einer Chip-on-board (COB) Technologie befestigt sein. Die Verwendung der SMD (Surface-mounted device) Technologie ist alternativ auch denkbar.

Erfindungsgemäß kann das durch die Lackschicht hindurchgehende Licht des LED-Chips aufgrund der darunter liegenden metallischen Schicht zurückreflektiert werden. Diese doppelt reflektive Ausgestaltung Lackschicht/Metallschicht hat den Vorteil, dass beispielsweise bei einer oxidativen Schwärzung der Metallschicht (bspw. Silberschicht) immer noch ein wesentlicher Anteil des Lichts durch die darüber liegende Lackschicht reflektiert wird, was den Wirkungsgrad des Moduls steigert. Gleichzeitig ist die Wärmeleitfähigkeit des Moduls durch die Anwendung der erfindungsgemäßen Metallschicht verbessert.

Erfindungsgemäß ist der LED-Chip auf der metallischen Schicht aufgebracht. Die Lackschicht ist dann in Bereichen auf der metallischen Schicht außerhalb des LED-Chips aufgebracht. Folglich weist die Lackschicht Freistellen auf, in die die LED-Chips eingesetzt und auf die metallische Schicht aufgebracht werden können.

Der LED-Chip kann auf die metallische Schicht mittels eines Klebers geklebt sein. Der Kleber kann beispielsweise ein transparenter durchscheinender Kleber oder ein reflektierender, also insbesondere weißer Kleber sein. Vorzugsweise füllt der Kleber eine Lücke zwischen der Seitenwand des LED-Chips und einer dem LED-Chip zugewandten Randbegrenzung der keramischen Lackschicht wenigstens teilweise oder vollständig aus, so dass die Metallschicht (bspw. Silberschicht) im letztgenannten Fall vollständig abgedeckt ist. Ist der Kleber aus einem lichtreflektierenden Material, so kann die gesamte Trägeroberfläche mit einer doppelt reflektiven Ausgestaltung ausgebildet werden.

Der Abstand zwischen der Seitenwand des LED-Chips und der Lackschicht liegt vorzugsweise in einem Bereich zwischen 50 und 500µm, besonders vorzugsweise zwischen 100 bis 300µm.

Die Lackschicht kann eine mittlere Dicke von 10 bis 100µm, vorzugsweise eine mittlere Dicke von 20 bis 50µm aufweisen.

Die metallische Schicht kann eine Stärke von 30 bis 8000nm aufweisen, vorzugsweise eine Stärke von 100 bis 300nm oder 2000 bis 6000nm. Im Falle einer Silberschicht hat diese vorzugsweise eine Stärke bzw. mittlere Dicke von 3000 bis 5000nm. Im Falle einer Goldschicht hat diese vorzugsweise eine Stärke bzw. mittlere Dicke von 30 bis 100nm.

Das LED-Modul kann weiterhin einen den LED-Chip bzw. mehrere LED-Chips seitlich umgebenden und die LED-Chips vorzugsweise in der Höhe überragenden Damm aufweisen, welcher wenigstens teilweise auf der metallischen Schicht und/oder der Lackschicht aufgebracht ist.

Vorzugsweise weist das LED-Modul ferner eine zentrale Füllung aus einem Matrixmaterial auf. Das Matrixmaterial kann ein transparentes und vorzugsweise flüssiges und durch Temperatur härtbares Polymer sein; z.B. Silikon. Die zentrale Füllung füllt vorzugsweise den von dem Damm umgebenden Raum (vollständig) aus. Besonders vorzugsweise ist dabei die Oberseite des LED-Chips bedeckt bzw. beschichtet.

Die zentrale Füllung kann folglich das gesamte durch den Damm begrenzte Volumen ausfüllen, so dass die Oberseite der Füllung auf derselben Ebene wie die maximale Höhe des Dammes liegt. Vorzugsweise ist der Damm, also die Damm-Oberkante, höher als der LED-Chip (d.h. dessen Oberkante), so dass dann die Oberseite des LED-Chips beschichtet bzw. von der Füllung abgedeckt und geschützt ist.

Die zentrale Füllung kann Farbkonversionspartikel/Leuchtstoffpartikel aufweisen, welche Licht, das von einem LED-Chip emittiert wird, in Licht eines zweiten, geringeren Frequenzspektrums verändert. Alternativ oder zusätzlich kann die zentrale Füllung Streupartikel aufweisen, welche Licht, das von einem LED-Chip emittiert wird, streut, um dadurch eine homogenere Emission zu ermöglichen.

Das Material des Dammes und das Material der zentralen Füllung können von der gleichen Materialklasse sein, vorzugsweise auf Silikonbasis. Besonders vorzugsweise sind der Damm und die zentrale Füllung aus einem Polymer bzw. Harz mit derselben Struktur hergestellt, wodurch es ermöglicht wird, den Damm und die Füllung beide in einem Härtungsschritt aufzubringen bzw. auszuhärten. Besonders vorzugsweise haben das Material bzw. das Polymer des Dammes und der zentralen Füllung eine ähnliche chemische Struktur welche vorzugsweise eine Quervernetzung zwischen den Materialien erlaubt. Sie können auch durch die gleiche Reaktion polymerisiert werden und sich nur durch die sich ergebende Shore Härte unterscheiden, z.B. für den Damm eine ShoreA Härte von 70 und für die Füllung eine ShoreA Härte von 35. Sie können auch aus einem identischen Material hergestellt sein, welches bspw. nur durch die verwendeten Füllstoffe zu einer unterschiedlichen funktionellen Ausprägung gelangt.

Wie zuvor beschrieben, kann auch der Damm aus einem Harz oder einem Polymermaterial hergestellt sein. Unterschiedliche Basisharze können für den Damm benutzt werden. Bevorzugte Materialien sind Silikone, aufgrund ihrer hohen UV-Stabilität. Das Material des Dammes kann Füllstoffe in Form von partikelförmigem Material wie z.B. pyrogener Kieselsäure (Siliziumdioxid; SiO2) aufweisen, wobei partikelförmiges Material oder fein granuliertes Material verwendet werden kann, um die gewünschten rheologischen Eigenschaften des ungehärteten Polymers zu bestimmen. Das Damm-Material ist vorzugsweise für die Wellenlänge des Lichtes, welches durch die zentrale Füllung innerhalb des Dammes dringt, nicht transparent (bzw. hoch reflektierend). Eine transparente oder durchscheinende Ausprägung des Dammes ist gemäß einer alternativen Ausführungsform der Erfindung denkbar.

Zumindest die innere Wand des Dammes kann lichtreflektierend/streuend sein. Besonders vorzugsweise weist der Damm Licht streuende Partikel, wie zum Beispiel weiße Pigmente (z.B. SiO2, TiO2, BaTiO3, SnO, ZrO2), auf. Diese reflektierenden/streuenden Partikel befinden sich vorzugsweise durchgehend in der Masse des Damms. Dadurch hat der Damm die Rolle eines in einem flüssigen Zustand auf eine (Leiter-)Platte aufgebrachten Reflektors. Der Damm kann 10 bis 60 Gewichtsprozent, besonders bevorzugt 20 bis 40 Gewichtsprozent der reflektierenden Partikel enthalten.

Der Damm kann ein vorgefertigtes Element sein, vorzugsweise aus einem Polymer (z.B. gefüllter Polymer/Harz), Keramik, Metall oder einem anderen (vorzugsweise gefüllten) Kunststoff.

Der Damm kann eine Höhe von 0,1mm bis 3mm haben, vorzugsweise 0,25mm bis 2mm, besonders vorzugsweise 0,5 bis 1mm.

Der Durchmesser der Querschnittsfläche des Dammes, also die durchschnittliche Dicke des Dammes bzw. der maximalen Abstand zwischen der inneren Wand und der äußeren Wand des Dammes, kann gemäß den Anforderungen des endgültigen Elementes gewählt werden. Vorzugsweise entspricht die Dicke im Wesentlichen der Höhe des Dammes. Bei einem Gesamtdurchmesser des Dammes von ungefähr 5mm kann dessen Dicke gleich oder weniger als 0,5mm sein. Für größere Durchmesser ist die Dicke entsprechend auf mehr als 0,5mm abgestimmt, wobei bei geringeren Durchmessern die Dicke auch weniger als 0,5mm sein kann.

Die Querschnittsform des Dammes ist nicht durch die Erfindung beschränkt.

Der Damm kann in der Draufsicht, also senkrecht zum Träger bzw. der Leiterplatte gesehen, eine kreisförmige, ellipsoide, ovale, oder eckige bzw. polygone Form, beispielsweise eine rechteckige oder quadratische oder achteckige Form, aufweisen.

Die Erfindung bezieht sich ferner auf ein Spotlight, ein Downlight oder eine Retrofit LED-Lampe, welche wenigstens ein LED-Modul gemäß der Erfindung aufweisen.

Die Erfindung bezieht sich auch auf ein LED- Modul, das herstellbar ist durch ein Verfahren zur Herstellung eines LED-Moduls. Zuerst wird eine metallische Schicht, vorzugsweise eine Silberschicht oder eine Goldschicht, auf einen Träger, insbesondere eine Leiterplatte aufgebracht. Die Schichtdicke kann dabei dadurch gesteigert werden, dass mehrere Beschichtungsschritte bzw. Beschichtungsvorgänge nacheinander durchgeführt werden.

Die reflektierende Metallschicht, insbesondere eine Silberoberfläche, kann durch Beschichtung mit Titanoxid, Aluminiumoxid oder Glas zusätzlich vor Oxidation geschützt werden. In diesem Falle dient der weiße Lack primär der Optimierung des Lichtoutputs.

Danach wird ein keramischer Lack auf den Träger - genauer die metallische Schicht des Trägers - derart aufgebracht, dass diese (r) von einer Lackschicht teilweise bedeckt ist. Ist die metallische Schicht nur teilweise, also partiell bedeckt, weist die Lackschicht folglich überall dort Freistellen auf, wo kein Lack ist. Vorzugsweise wird die Lackschicht aufgedruckt, beispielsweise mittels Siebdruckverfahren.

Anschließend (oder auch vor, während oder nach einem der vorgenannten Schritte) wird wenigstens ein LED-Chip auf dem Träger, der metallischen Schicht oder der Lackschicht platziert.

Der LED-Chip wird in den Freistellen der Lackschicht auf die metallische Schicht geklebt. Dies geschieht vorzugsweise mittels eines reflektierenden, besonders vorzugsweise weißen Klebers. Die Dosierung des Klebers wird vorzugsweise derart gewählt, dass beim Platzieren des LED-Chips auf den Kleber in den Freistellen der Kleber seitlich derart verdrängt wird, sodass er die verbleibende Lücke zwischen der Seitenwand des LED-Chips und einer dem LED-Chip zugewandten Randbegrenzung der keramischen Lackschicht wenigstens teilweise oder vollständig ausfüllt, so dass die metallische Schicht im letztgenannten Fall vollständig abgedeckt ist.

Es besteht ferner die Möglichkeit, einen Damm wenigstens teilweise auf der metallischen Schicht und/oder der Lackschicht derart aufzubringen, dass der Damm den wenigstens einen LED-Chip seitlich umgibt. Im Anschluss daran wird der von dem Damm umgebende Raum mit einem Füllmaterial zum Bilden einer zentralen Füllung ausgefüllt. Die so entstehende zentrale Füllung wird vorzugsweise derart vorgesehen, dass sie die Oberseite des LED-Chips beschichtet.

Der Damm und die zentrale Füllung sind vorzugsweise aus einem flüssigen Polymer oder einer flüssigen Polymermischung hergestellt, das/die nach dem Aufbringen bzw. Ausfüllen gehärtet wird. Das Härten des Dammes und das Härten der zentralen Füllung können nach den jeweiligen Schritten zum Aufbringen des Dammes und der zentralen Füllung durchgeführt werden. Es ist alternativ auch möglich und besonders bevorzugt, das Härten der beiden Teile in einem einzelnen Schritt nach dem Vorsehen des Dammes und der zentralen Füllung durchzuführen. In diesem Fall kann eine chemisch und/oder physisch verbundene Grenzfläche zwischen dem Damm und der zentralen Füllung hergestellt werden. Wenn das gleiche Basispolymer verwendet wird, kann auch keine Grenzfläche im eigentlichen Sinne entstehen.

Aspekte der Erfindung sind insbesondere:
Ein LED-Modul, aufweisend:
- einen Träger mit hohem Reflexionsgrad, wobei auf dem Träger eine metallische Schicht, vorzugsweise eine Silberschicht oder eine Schicht aus Reinstaluminium, aufgebracht ist.

Das LED-Modul weist eine Oxidschicht über der metallischen Schicht auf.

Über der metallischen Schicht und der Oxidschicht ist eine Lackschicht vorgesehen

Das LED-Modul weist einen LED-Chip auf der metallischen Schicht oder der Oxidschicht auf.

Die metallische Schicht kann aus einer bondbaren oder zumindest in Teilbereichen bondbaren Oberfläche bestehen, und wobei diese in den nicht bondbaren Oberflächenbereichen zusätzlich durch Oxide oder organische Schicht(en) gegen Veränderung geschützt ist.

Die metallische Schicht kann zusätzlich durch Oxide oder organische Schicht(en) gegen Veränderung geschützt sein.

Das LED-Modul ist derart ausgestaltet, dass wenigstens ein Teil von auf das Modul fallendem Licht, bspw. von einem auf dem Modul anbringbaren LED-Chip, durch die Metallschicht reflektiert wird.

Ein LED-Modul weist auf :
- einen Träger mit hohem Reflexionsgrad, wobei auf dem Träger eine metallische Schicht, vorzugsweise eine Silberschicht oder eine Schicht aus Reinstaluminium, aufgebracht ist,
- eine Oxidschicht über der metallischen Schicht,
wobei über der metallischen Schicht und ggf. der Oxidschicht eine Lackschicht vorgesehen ist, weiterhin optional einen LED-Chip auf der metallischen Schicht oder der Oxidschicht, wobei das LED-Modul derart ausgestaltet ist, dass wenigstens ein Teil von auf das Modul fallendem Licht, bspw. von einem auf dem Modul anbringbaren LED-Chip, durch die Metallschicht reflektiert wird.

Ein LED-Modul kann aufweisen:
- einen Träger mit hohem Reflexionsgrad, wobei auf dem Träger eine metallische Schicht aufgebracht ist,
- wenigstens einen LED-Chip, und
- einen Damm,
- wobei die metallische Schicht teilweise die unter dem Damm liegende Oberfläche des Trägers bedeckt.

Das LED-Modul weist eine Lackschicht auf, die teilweise auf der metallischen Schicht aufgebracht ist.

Der LED-Chip kann auf der metallischen Schicht und/oder direkt auf dem Träger aufgebracht sein.

Die Lackschicht kann eine mittlere Dicke von 5 bis 250µm, bevorzugt 10 bis 100µm, vorzugsweise 20 bis 50µm aufweisen.

Die metallische Schicht kann eine Stärke von 30nm bis 8000nm, vorzugsweise eine Stärke von 100nm bis 300nm oder 2000nm bis 6000nm aufweisen.

Die Lackschicht kann auf der metallischen Schicht positioniert sein und den von dem Damm umgebenden Raum vollständig überdecken und/oder bis zur Oberfläche des Trägers unter dem Damm ragen, wobei der Träger mindestens einen von der Lackschicht unbedeckten Bereich aufweist.

Der Träger kann eine Leiterplatte und/oder ein Basissubstrat beinhalten.

Die Leiterplatte und das Basissubstrat können mit Hilfe von einem zusätzlichen Substrat bspw. durch Klebevorgang verbunden werden/sein.

Das Basissubstrat kann eine Dicke von 0,5 bis 5mm, vorzugsweise 1-1,5mm, weiterhin bevorzugt 1,5 bis 2mm aufweisen.

Die Leiterplatte kann vorzugsweise wenigstens eine Ausnehmung (d.h. Ausschnitt oder Vertiefung) in einem Bereich aufweisen, in dem die LED-Chips vorgesehen sind.

Sogenannte Mid- und/oder Low-power LED-Chips können in Serie geschaltet in Strängen strukturiert innerhalb eines Dammes montiert sein.

Ein Strang kann dabei 5-26 LED-Chips, mehr bevorzugt 8-20 LED-Chips, besonders bevorzugt 10-15 LED-Chips enthalten.

Die LED-Chips können bevorzugt in 1-15 Strängen, mehr bevorzugt in 3-12 Strängen auf dem LED-Modul eingerichtet sein.

Das LED-Modul kann vorzugsweise mit von 10 bis 370 LED-Chips, besonders bevorzugt mit von 20 bis 120 LED-Chips gleichmäßig mit geringem Abstand zueinander bestückt sein.

Das LED-Modul kann weiterhin einen Reflektor und ein zusätzliches Substrat aufweisen.

Der Damm kann den LED-Chip bzw. mehrere LED-Chips seitlich umgeben und die LED-Chips vorzugsweise in der Höhe überragen, welcher wenigstens teilweise auf der metallischen Schicht und/oder der Lackschicht aufgebracht sind, und
- vorzugsweise ferner eine zentrale Füllung aus einem Matrixmaterial, vorzugsweise ein transparentes und vorzugsweise flüssiges und durch Temperatur härtbares Polymer oder eine Polymermischung aufweisen, wobei die zentrale Füllung den von dem Damm umgebenden Raum vorzugsweise vollständig ausfüllt, so dass die Oberseite des LED-Chips beschichtet ist.

Die zentrale Füllung kann Farbkonversionspartikel und/oder Streupartikel aufweisen.

Das Material des Dammes und das Material der zentralen Füllung können von der gleichen Materialklasse sein, vorzugsweise auf Silikonbasis, besonders vorzugsweise sind der Damm und die zentrale Füllung aus einem Polymer bzw. Harz mit derselben Struktur hergestellt, wodurch es ermöglicht wird, den Damm und die Füllung beide in einem Härtungsschritt auszuhärten.

Das Material des Dammes kann Füllstoffe in Form von partikelförmigem Material wie z.B. Siliziumdioxid aufweisen.

Zumindest die innere Wand des Dammes kann lichtreflektierend oder streuend sein, und/oder der Damm kann reflektierende oder lichtstreuende Partikel, vorzugsweise weiße Pigmente, aufweisen.

Der Damm kann ein vorgefertigtes Element sein, vorzugsweise aus einem Polymer, Keramik, Metall oder Kunststoff.

Der Damm kann eine Höhe von 0,1 bis 3mm haben, vorzugsweise von 0,25 bis 2mm, besonders vorzugsweise von 0,5mm bis 0,8mm. Der Durchmesser der Querschnittsfläche des Dammes, also die durchschnittliche Dicke des Dammes bzw. der maximalen Abstand zwischen der inneren Wand und der äußeren Wand des Dammes entspricht vorzugsweise im Wesentlichen der Höhe des Dammes.

Der Damm kann in der Draufsicht, also senkrecht zum Träger gesehen, eine kreisförmige, ellipsoide, ovale oder eckige Form, beispielsweise eine rechteckige oder quadratische oder polygone Form, aufweisen.

Ein Spotlight oder Retrofit LED-Lampe weist wenigstens ein LED-Modul der oben genannten Art auf, vorzugsweise ferner weiterhin eines oder mehreres von:
- einem Gehäuse,
- einem Reflektor,
- einer Treiberschaltung,
- einer Sensorik,
- einem Kühlkörper und/oder
- einem Lampensockel.

Ein LED-Modul mit einem Träger mit hohem Reflexionsgrad ist herstellbar durch ein Verfahren, das die folgenden Schritte aufweist:
- Aufbringen einer metallischen Schicht auf einen Träger,
- Aufbringen eines keramischen Lacks auf den Träger derart, dass die metallische Schicht des Trägers von einer Lackschicht teilweise bedeckt ist,
- Platzieren von wenigstens einem LED-Chip auf dem Träger, der metallischen Schicht.

Das LED-Modul kann weiterhin herstellbar sein durch ein Verfahren, das ferner die Schritte aufweist:
- Aufbringen eines Damms wenigstens teilweise auf der metallischen Schicht und/oder der Lackschicht derart, dass der Damm den wenigstens einen LED-Chip seitlich umgibt,
- Ausfüllen des von dem Damm umgebenden Raums mit einem Füllmaterial, wobei die so entstehende zentrale Füllung vorzugsweise derart vorgesehen wird, dass sie die Oberseite des LED-Chips beschichtet,
wobei der Damm und die zentrale Füllung vorzugsweise aus einem flüssigen Polymer oder einer Polymermischung hergestellt sind, das/die nach dem Aufbringen bzw. Ausfüllen gehärtet wird, und
wobei das Härten des Dammes und das Härten der zentralen Füllung nach den jeweiligen Schritten zum Vorsehen des Dammes und der zentralen Füllung durchgeführt werden, oder in einem einzelnen Schritt nach dem Vorsehen des Dammes und der zentralen Füllung, wobei in letzterem Fall vorzugsweise eine chemisch und/oder physisch verbundene Grenzfläche zwischen dem Damm und der zentralen Füllung hergestellt wird.

Das LED-Modul kann weiterhin durch ein Verfahren herstellbar sein, das ferner die Schritte aufweist, dass mehrere Schritte zum Aufbringen des keramischen Lacks auf die metallische Schicht vorgesehen sind, so dass die Schichtdicke der Lackschicht erhöht wird.

Das LED-Modul kann weiterhin durch ein Verfahren herstellbar sein, das ferner die Schritte aufweist, wobei der keramische Lack auf die metallische Schicht aufgedruckt wird, vorzugsweise mittels eines Siebdruckverfahrens oder eines Dispensverfahrens.

Das LED-Modul ist weiterhin durch ein Verfahren herstellbar, das ferner die Schritte aufweist, wobei der keramischen Lack auf die metallische Schicht derart aufgebracht wird, dass diese von der Lackschicht nur partiell bedeckt ist und Freistellen aufweist,
wobei der LED-Chip vorzugsweise in den Freistellen der Lackschicht auf die metallische Schicht geklebt wird, vorzugsweise mit einem reflektierenden, besonders vorzugsweise weißen Kleber, und
wobei die Dosierung des Klebers vorzugsweise derart gewählt wird, dass beim Platzieren des LED-Chips auf den Kleber in den Freistellen der Kleber seitlich derart verdrängt wird, sodass er die verbleibende Lücke zwischen der Seitenwand des LED-Chips und einer dem LED-Chip zugewandten Randbegrenzung der keramischen Lackschicht wenigstens teilweise oder vollständig ausfüllt, so dass die metallische Schicht im letztgenannten Fall vollständig abgedeckt ist.

Weitere Aspekte, Vorteile und Objekte der vorliegenden Erfindung werden durch die folgende detaillierte Beschreibung eines Ausführungsbeispiels und nicht zur Erfindung gehörender Erläuterungsbeispiele offensichtlich werden, wenn sie in Zusammenhang mit den beiliegenden Zeichnungen gebracht werden.
Figur 1A zeigt eine Schnittansicht eines LED-Moduls gemäß der ersten Ausführungsform der Erfindung,
Figur 1B zeigt eine Schnittansicht eines LED-Moduls gemäß einem ersten nicht zur Erfindung gehörenden Erläuterungsbeispiel,
Figur 1C zeigt eine Schnittansicht eines LED-Moduls gemäß einem zweiten nicht zur Erfindung gehörenden Erläuterungsbeispiel,
Figur 1D zeigt eine Schnittansicht eines LED-Moduls gemäß einem dritten nicht zur Erfindung gehörenden Erläuterungsbeispiel, und
Figur 2A-C zeigt die Übersichten der LED-Module gemäß der Erfindung,
Figur 3 zeigt eine Teilschnittansicht einer Retrofit-LED-Lampe mit einem LED-Modul gemäß der Erfindung, und Figur 4 zeigt eine Schnittansicht eines LED-Moduls gemäß einer weiteren Ausführungsform der Erfindung.

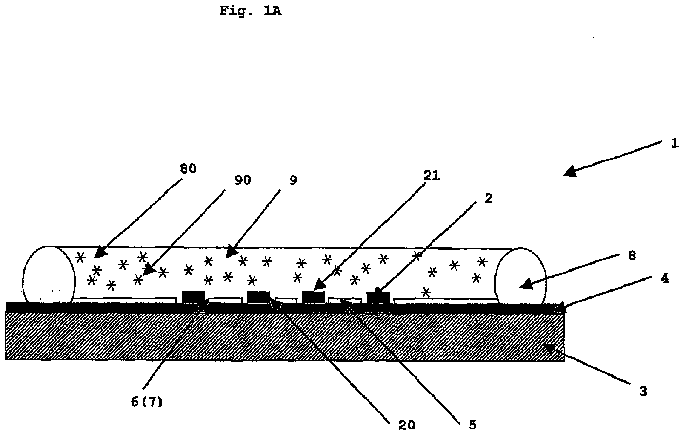

Figur 1A zeigt ein LED-Modul 1 (im Folgenden auch Modul genannt) gemäß einer Ausführungsform der Erfindung. Das Modul 1 weist wenigstens eine lichtemittierende Diode (LED-Die bzw. LED-Chip) 2 auf. Die Anzahl der LED-Chips 2 ist durch die Erfindung nicht begrenzt. Der LED-Chip 2 hat vorzugsweise eine Höhe von 50 bis 500µm, vorzugsweise 100 bis 200µm.

Die LED-Chips 2 sind auf dem Träger 3 aufgebracht. Als LED-Chips 2 können amber, rote, grüne, und/oder blaue LED-Chips 2 (bspw. RGB) oder blaue und rote LEDs zur Erzeugung monochromatischen, weißen oder andersfarbigen, gemischten Lichts eingesetzt werden. Ferner kann der LED-Chip 2 mit einem über dem LED-Chip 2 angeordneten photolumineszierenden Material, wie beispielsweise, anorganische Leuchtstoff (e) (beispielsweise Granaten: YAG: Ce³⁺, LuAG: Ce³⁺; Orthosilikaten (BOSE) : (Ca, Sr, Ba)₂SiO₄:Eu²+, (Ca, Sr)₂SiO₄:Eu²⁺, (Sr, Ba)₂SiO₄:Eu²⁺, (Ca, Ba)₂SiO₄:Eu²⁺; Nitride: CaAlSiN₃: Eu²⁺, (Sr,Ca)AlSiN₃: Eu²⁺, CaAlSiON₃: Eu²⁺, β-SiAlON: Eu²⁺)) und/oder organische Leuchtstoff(e), versehen sein, mittels der/deren das vom LED-Chip 2 abgestrahlte Licht und das in dem photolumineszierendem Material umgewandelte Licht derart miteinander vermischt werden, dass jede gewünschte Farbe oder weißes Licht (bspw. mittels blauer LED und gelbem (und/oder grünem und/oder rotem) Leuchtstoff) erzeugt werden kann. Es ist auch jegliche Kombination der vorgenannten LED-Chips 2 in dem LED-Modul 1 denkbar.

Das Modul 1 besteht aus einem Träger 3 und einer vorzugsweise strukturierten metallischen Schicht 4. Der Träger 3 ist vorzugsweise eine Leiterplatte, wobei der Träger 3 aus einem Metallkern, vorzugsweise aus einer Aluminiumplatte, und einem elektrisch isolierenden Dielektrikum und strukturierten Kupferleiterbahnen besteht. Auf dem Träger 3 ist die metallische Schicht 4 aufgebracht; vorzugsweise ist der Träger 3 mit der metallischen Schicht 4 beschichtet. Die metallische Schicht 4 ist vorzugsweise eine Silberschicht, eine Goldschicht, eine ENIG (Electroless Nickel/Immersion Gold), eine ENEPIG (Electroless Nickel/Electroless Palladium/Immersion Gold) oder eine ENEC/OSP (Electroless Ni/Electroless Cu/OSP (Organic Surface Protection)) und bedeckt vorzugsweise die gesamte Trägeroberfläche. Die metallische Schicht 4 kann aus einer bondbaren oder zumindest in Teilbereichen bondbaren Oberfläche bestehen, wobei diese in den nicht bondbaren Oberflächenbereichen zusätzlich durch Oxide oder organische Schicht(en) gegen Veränderung geschützt sein kann.

Die Schicht 4 hat vorzugsweise eine Stärke von 30 bis 8000nm, besonders vorzugsweise eine Stärke von 100 bis 300nm oder 2000 bis 6000nm. Diese Obergrenze ist teilweise technisch, aber auch durch die Kosten für das Silber- bzw. Goldmaterial als Kompromiss bedingt. Erfindungsgemäß sind also auch stärkere/dickere Beschichtungen denkbar.

Eine Lackschicht 5 kann beispielsweise aus einer hochreflektierenden weißen Paste derart vorgesehen werden, dass sie die metallische Schicht 4 wenigstens im Wesentlichen überdeckt. Hierzu ist die Lackschicht 5 auf dem Träger 3, genauer der metallischen Schicht 4 des Trägers 3 aufgebracht; vorzugsweise mittels eines Dispensverfahrens oder eines Siebdruckverfahrens. Die Lackschicht 5 in dieser Ausführungsform weist vorzugsweise eine Stärke bzw. mittlerer Dicke von 5 bis 250µm, mehr bevorzugt 20 bis 200µm, besonders vorzugsweise 100 bis 150µm auf.

Die Lackschicht 5 kann als eine (hoch)reflektierende keramische weiße Schicht oder als eine weiße (hoch)reflektierende Beschichtung realisiert sein. Die Lackschicht 5 ist vorzugsweise eine weiße Beschichtung enthält vorzugsweise Pigmente aus Titandioxid (ein Polymorph von TiO₂ z.B. TiO₂(B)), Aluminiumoxid (Al₂O₃), Zirconiumdioxid (ZrO₂), Bariumtitanat (BaTiO₃), Siliciumdioxid (SiO₂), oder Kaliumoktatitanat (K₂Ti₈O₁₇). Die Pigmente bestehen vorzugsweise aus einer Mischung von TiO₂ und/oder TiO₂(B) und/oder K₂Ti₈O₁₇ und/oder SiO₂. Die Dispersion beinhaltet ferner vorzugsweise ein organisches (z.B. Ether(s), Branched polymeric siloxane(s), bevorzugt Methyl und/oder Hydroxy terminated Silsesquioxanes) und/oder ein anorganisches Lösungsmittel zB. Wasser. Die Anwendung von einer Mischung von organischen und anorganischen Lösungsmitteln ist auch ausführbar.

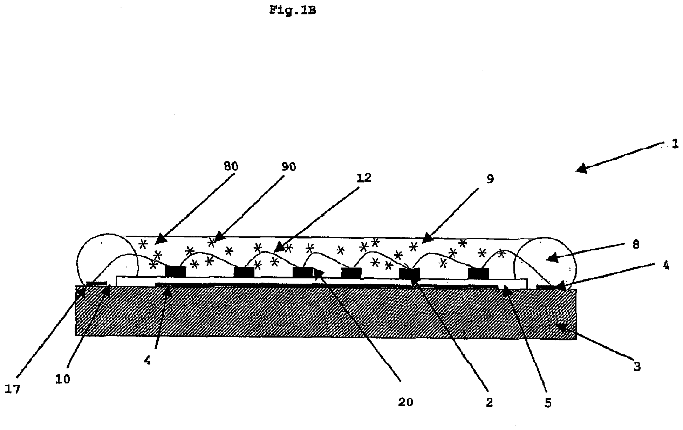

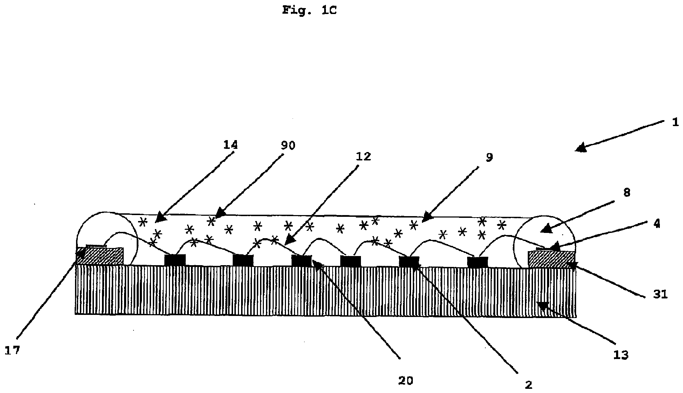

In einer bevorzugten Ausführungsform ist der wenigstens ein LED-Chip 2 auf der metallischen Schicht 4 (ggf. mit vorbeschriebener Schutzbeschichtung) direkt aufgebracht und elektrisch kontaktiert (bspw. in einer Ausnehmung einer (FR4) Leiterplatte). Der LED-Chip 2 kann hierzu übereinstimmend mit einer Chip-on-board (COB) Technologie befestigt werden. Der LED-Chip 2 kann jedoch auch auf dem Träger 3 oder der Lackschicht 5 aufgebracht (wie Fig. 1B, 1C) sein. Ist der LED-Chip 2 auf der metallischen Schicht 4 aufgebracht, so ist die Lackschicht 5 lediglich in Bereichen auf der metallischen Schicht 4 außerhalb des LED-Chips 2 aufgebracht. Die Lackschicht 5 wird dann vorzugsweise auf die metallische Schicht 4 aufgebracht, bevor die LED-Chips 2 auf die metallische Schicht 4 aufgebracht werden. Wie im Weiteren noch beschrieben wird, wird die Lackschicht 5 hierzu derart vorgesehen, dass Freistellen 6 verbleiben. In diesen Freistellen 6 wird der LED-Chip 2 auf die metallische Schicht 4 aufgebracht.

Der Abstand zwischen der Seitenwand 20 des LED-Chips 2 und der Lackschicht 5 (also einer Randbegrenzung 50 der Lackschicht 5, welche durch die Freistelle 6 definiert ist) liegt vorzugsweise in einem Bereich zwischen 50 und 500µm, besonders vorzugsweise zwischen 100 bis 300pm.

Der LED-Chip 2 wird vorzugsweise auf die metallische Schicht 4 mittels eines Klebers (nicht gezeigt) geklebt. Der Kleber kann ein reflektierender, vorzugsweise weißer Kleber sein. In einer bevorzugten Ausgestaltungsform füllt der Kleber eine Lücke 7 zwischen der Seitenwand 20 des LED-Chips 2 und einer dem LED-Chip 2 zugewandten Randbegrenzung 50 der keramischen Lackschicht 5 wenigstens teilweise oder vollständig aus, so dass die metallische Schicht 4 im letztgenannten Fall vollständig durch die Lackschicht 5, die LED-Chips 2 sowie den Kleber abgedeckt ist. In einer weiteren bevorzugten Anwendung ist der Kleber transparent.

Das Modul 1 kann ferner einen den LED-Chip 2 bzw. die mehreren LED-Chips 2 seitlich umgebenden Damm 8 aufweisen, welcher wenigstens teilweise auf der metallischen Schicht 4 und/oder der Lackschicht 5 aufgebracht ist. Der Damm 8 ist vorzugsweise von dem LED-Chip 2 seitlich beabstandet vorgesehen.

Vorzugsweise füllt eine zentrale Füllung 9 den von dem Damm 8 umgebenden Raum 80 aus. Vorzugsweise füllt die zentrale Füllung 9 das gesamte durch den Damm 8 begrenzte Volumen aus; der durch den Damm 8 gebildete Innenraum 80 ist somit vorzugsweise bis zur höchsten Erstreckung des Damms 8 mit der Füllung 9 ausgefüllt. Ist der Damm 8 gemäß einer bevorzugten Ausgestaltung höher als der LED-Chip 2 ausgebildet und überragt diesen folglich in der Höhe, so kann die Oberseite 21 des LED-Chips 2 mit dem Füllmaterial bedeckt bzw. beschichtet sein; wenigstens dann, wenn das durch den Damm 8 begrenzte Volumen vollständig mit der zentralen Füllung 9 ausgefüllt ist. Vorzugsweise ist die Höhe des Dammes 8 mindestens zwei- oder dreimal so hoch wie die Höhe des LED-Chips 2. Der Damm 8 hat vorzugsweise eine Höhe von 0,1 bis 3mm, besonders vorzugsweise 0,25 bis 2mm, höchst vorzugsweise 0,5 bis 1mm. Der Durchmesser der Querschnittsfläche des Dammes 8, also die durchschnittliche Dicke des Dammes 8 bzw. der maximalen Abstand zwischen der inneren Wand und der äußeren Wand des Dammes 8, entspricht im Wesentlichen der Höhe des Dammes 8.

Die zentrale Füllung 9 ist vorzugsweise aus einem Matrixmaterial hergestellt, besonders vorzugsweise aus einem transparenten, vorzugsweise flüssigen und durch Temperatur härtbaren Polymer bzw. Harz oder einer Polymermischung. Vorzugsweise weist die zentrale Füllung 9 Farbkonversionspartikel und/oder Streupartikel 90 auf.

In einer besonders bevorzugten Ausgestaltungsform sind das Material des Dammes 8 und das Material der zentralen Füllung 9 von der gleichen Materialklasse, vorzugsweise auf Silikonbasis. Der Damm 8 und die zentrale Füllung 9 können bspw. aus einem Polymer mit derselben Struktur hergestellt sein. Hierdurch wird es ermöglicht, den Damm 8 und die Füllung 9 beide in einem Härtungsschritt aufzubringen, wie im Folgenden noch beschrieben wird.

Die rheologischen Charakteristiken des flüssigen Polymermaterials zum Aufbau der Wand des Dammes 8 müssen derart ausgewählt werden, dass das ungehärtete Polymer bzw. Harz nach der Abgabe bis zur Härtung formstabil ist. Durch entsprechende Beimengung von geeigneten Füllstoffen kann dieser annähernd festkörperartige Zustand erreicht werden.

Um die rheologischen Charakteristiken des flüssigen Polymers bzw. Harzmaterials zu steuern, können pyrogene Kieselsäure (Siliziumdioxid; SiO₂) oder andere partikelförmige Materialien (fein gekörnte Materialien) als Füllstoffe dem flüssigen Polymer bzw. Harz zugefügt werden. Das Damm-Material ist vorzugsweise für die Wellenlänge des Lichtes, welches durch die zentrale Füllung 9 innerhalb des Dammes 8 dringt, reflektierend.

Falls ein höheres Reflexionsvermögen der Wand des Dammes 8 gewünscht wird, kann beispielsweise zumindest die innere Wand des Dammes mit Metall beschichtet oder der Damm aus Metall gefertigt werden. Bei dieser Ausführungsform können jedoch Isolationsprobleme auftreten.

Besonders vorzugsweise weist der Damm 8 alternativ oder zusätzlich (hoch-)reflektierende und/oder effektiv streuende Partikel mit geringer Absorption, wie zum Beispiel weiße Pigmente, auf. Hierzu können die reflektierenden Materialien dem flüssigen Polymer bzw. Harz zugefügt werden. Solche Pigmente sind bspw. aus TiO₂, BaTiO₃, BaSO₄ und/oder ZrO₂ hergestellt. Diese reflektierenden Partikel befinden sich vorzugsweise durchgehend in der Masse des Damms 8. Der Damm 8 kann 10 bis 60 Gewichtsprozent der reflektierenden Partikel enthalten. Dadurch wird das gesamte Material des Dammes 8 ein nicht transparentes und vorzugsweise weißes Aussehen haben. Die Reflexion von Licht von dem LED-Chip 2 geschieht an der inneren Fläche des Dammes 8, wodurch Licht zurück in das Innere des Dammes 8, und von dem LED Chip 2 fort reflektiert wird. Dadurch hat der Damm 8 die Rolle eines in einem flüssigen Zustand auf dem Träger 3 bzw. der metallischen Schicht 4 bzw. der Lackschicht 5 aufgebrachten Reflektors.

Der Damm 8 kann mittels Dispenstechniken aufgebracht werden, wie im Weiteren noch beschrieben. Es ist jedoch auch möglich, dass der Damm 8 ein vorgefertigtes Element ist, vorzugsweise aus einemPolymer, Keramik, Metall oder einem anderen Kunststoff. Dieses Element kann dann bspw. an der vorgesehenen Stelle aufgeklebt werden.

Der Damm 8 weist vorzugsweise die Querschnittsform eines Halbkreises, eines Kreises, eines Rechtecks oder eines Quadrates oder eines Polygons auf. In der Draufsicht, also senkrecht zum Träger 3 gesehen, weist der Damm 8 eine kreisförmige, ovale, ellipsoide oder eckige Form, beispielsweise eine rechteckige oder quadratische oder polygone Form, auf. Es sei an dieser Stelle festgehalten, dass der Begriff "Damm" keine Beschränkung bezüglich der Gestalt darstellt, solange der Damm 8 als ein die innere, zentrale Füllung 9 umgebender Damm 8 dienen kann, und, ist der Damm 8 aus einem Polymer bzw. Harzmaterial, dieser bereits im ungehärteten Zustand stabil ist.

Fig. 1B stellt ein erstes nicht zur Erfindung gehörendes Erläuterungsbeispiel dar. Im Vergleich zu der Lösung in Fig. 1A bedeckt die Metallschicht 4 nur teilweise den Träger 3, vorzugsweise sind die Bereiche unter den LED-Chips 2 und die Bondpads 11 (nicht gezeigt) mit der Metallschicht 4 überzogen. So ergeben sich die von Metallschicht 4 unbedeckte Bereiche 10 auf dem Träger 3. Die Lackschicht 5 überdeckt, im Gegensatz zur Erfindung, die Metallschicht 4 unten den LED-Chips 2, aber nicht die Metallschicht 4 aufgebracht auf den Bondpads 11. Die Lackschicht 5 erstreckt sich bis zur Trägeroberfläche 17 unter dem Damm 8. Die Lackschicht 5 bedeckt vorzugsweise vollständig die Oberfläche des Trägers 3 unter dem Damm 8. Die Lackschicht kann aber auf das Trägerbereich unter dem Damm 8 unvollständig aufgebracht werden.

Die Lackschicht 5 weist in dieser Ausführungsform vorzugsweise eine Stärke bzw. mittlerer Dicke von 10 bis 100µm, besonders vorzugsweise 20 bis 50µm auf. In dieser Ausführungsform liegen die LED-Chips 2 direkt auf der Lackschicht 5. Die LED-Chips 2 sind mit Bonddrähten 12 miteinander und mit den Bondpads 11 elektronisch verbunden. Die Banddrähte 12 sind teilweise von dem Damm 8 mechanisch geschützt, weil sie teilweise unter dem Damm 8 liegen.

Beispielsweise kann der Träger 3 mit Schicht 4 zusätzlich zu den erwähnten Beispielen auch nach Fig. 1C (zweites nicht zur Erfindung gehörendes Erläuterungsbeispiel) wie folgt aufgebaut sein, wobei der im Folgenden beschrieben Aufbau auch für sich genommen, also ohne die weiteren im Rahmen der Anmeldung beschriebenen Merkmale, in den gleichen oder anderen Gebieten der Leiterplattentechnik als vorteilhafte (hoch-)reflektive Leiterplatte eingesetzt werden kann. Zunächst wird ein Grundmaterial bzw. Basissubstrat 13 (bspw. Aluminiumplatte oder Goldplatte) bereitgestellt, welche(s) bspw. eine Dicke von 0,5 bis 5mm, vorzugsweise 1-1,5mm aufweist. Auf das Basissubstrat 13 wird wenigstens eine Schicht aus Reinstaluminium (99,99%) aufgebracht, vorzugsweise aufgedampft. Diese Schicht hat vorzugsweise eine Stärke von 30 bis 8000nm. Diese Reinstaluminiumschicht kann vorzugsweise wiederum in zuvor beschriebener Weise mit wenigstens einer Schicht aus Oxiden versehen werden, die ebenfalls vorzugsweise aufgedampft wird.

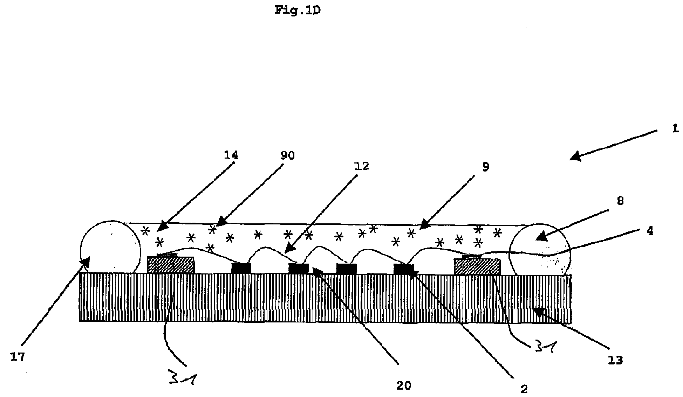

Das dritte, nicht zur Erfindung gehörende, Erläuterungsbeispiel von Figur 1D schliesslich stellt eine Modifikation des zweiten Erläuterungsbeispiels gemäss Figur 1C dar. Bei diesem Erläuterungsbeispiel sind die Leiterplatte 31, und die Schicht 4 teilweise oder vorzugsweise vollständig (wie dargestellt) innerhalb des Dammes 8 angeordnet, so dass der Damm 8 diese Bauteile nicht (wie dargestellt) oder nur teilweise überdeckt. Wie dargestellt verläuft vorzugsweise jeder Bonddraht 12, als insbesondere auch der dem Damm 8 am nächsten liegende, vollständig innerhalb des durch den Damm 8 nach Aussen abgegrenzten Volumens. Der Damm 8 sitzt somit vorzugsweise direkt und vollständig auf dem Basissubstrat 13 auf.

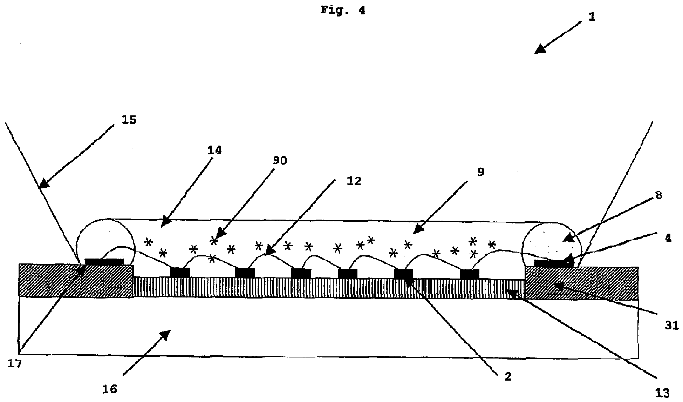

Auf den vorgenannten Aufbau wird eine Leiterplatte 31, vorzugsweise eine FR4 Leiterplatte aufgebracht, genauer verpresst bzw. auflaminiert. Basissubstrat 13 und Leiterplatte 31 bilden den Träger 3 in den Ausführungsformen gezeigt auf den Fig. 1B-1C und Fig. 4.

Alternativ kann die Leiterplatte 31 und das Basissubstrat 13 mit Hilfe von einem zusätzlichen Substrat 16 bspw. durch Klebevorgang oder Lötverfahren verbunden werden (Siehe Fig. 4) .

Vorzugsweise weist das elektrisch isolierende Basis- bzw. Trägermaterial (i.d.R. Epoxidharz getränkte Glasfasermatten) der Leiterplatte 31 eine Stärke von 30 bis 300µm, besonders vorzugsweise 100µm auf. Die auf dem Trägermaterial der (FR4) Leiterplatte 31 aufgebrachte Kupferschicht (Leiterbahnen) hat vorzugsweise eine Dicke von 18 bis 140µm, besonders vorzugsweise von 60 bis 90µm. Die Finishing-Oberfläche/Metallschicht 4 besteht aus Nickel und/oder Palladium und/oder Gold (wie früher erwähnt bspw. ENIG, ENEPIG oder ENEC/OSP). Die Metallschicht 4 ist vorzugsweise auf die Oberfläche der (FR4) Leiterplatte 31 (des Trägers 3) unter dem Dam 8 aufgebracht. Die Lötmaske ist vorzugsweise weiß.

Die Leiterplatte 31 weist ferner vorzugsweise wenigstens eine Ausnehmung 14 (z.B. Bohrung, Fräsung, etc.) in einem Bereich auf, in dem der oder die LED-Chips 2 vorgesehen sind. Diese Ausnehmung(en) 14 geben die darunterliegende Aluminiumschicht bzw. beschichtete Aluminiumplatte (oder Goldschicht) frei und stellen eine reflektierende Fläche auf dem (beschichteten) Basissubstrat 13 dar. Im Bereich der Ausnehmung(en) 14 kann der LED-Chip 2 bzw. können die LED-Chips 2 in der nachbeschriebenen Weise direkt auf das Basissubstrat 13 (ggf. mit vorbeschriebener Schutzbeschichtung aus Oxiden) aufgebracht werden. Mit einem derartigen Aufbau allein kann ein Träger 3 bzw. eine Leiterplatte bereitgestellt werden, welche eine hohe Robustheit (und somit eine gewisse Unzerstörbarkeit) der Konstruktion ermöglicht. Gleichzeitig werden die durch die Verwendung von Silber auftretenden Probleme - einschließlich vergleichsweise hoher Kosten von Silber - vermieden.

Eine Lackschicht 5 aus einem keramischen Lack bzw. einer keramischen hochreflektierenden weißen Paste kann nach einer weiteren Ausführungsform derart vorgesehen, dass sie das Basissubstrat 13 wenigstens teilweise überdeckt. Hierzu kann die Lackschicht 5 auf dem Basissubstrate 13 aufgebracht; vorzugsweise mittels eines Siebdruckverfahrens.

Hierzu kann die Lackschicht 5 bspw. auch besonders im Bereich einer möglichen Ausnehmung 14 in einer (FR4) Leiterplatte vorgesehen sein und ggf. ferner das Basissubstrat 13 und/oder die (FR4) Leiterplatte 31 überdecken (bspw. außerhalb der durch eine Ausnehmung 14 in der FR4 Leiterplatte freigelegten Bereiche des beschichteten Basissubstrats). Die Lackschicht 5 weist vorzugsweise eine Stärke bzw. mittlerer Dicke von 10 bis 100µm, besonders vorzugsweise 20 bis 50µm auf.

Alternativ kann einen Reflektor 15 auf der Leiterplatte 31 außerhalb des Dammes aufgebracht werden (Siehe Fig. 4).

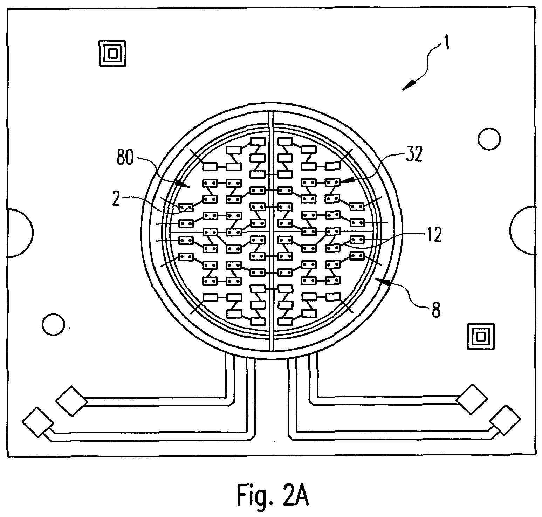

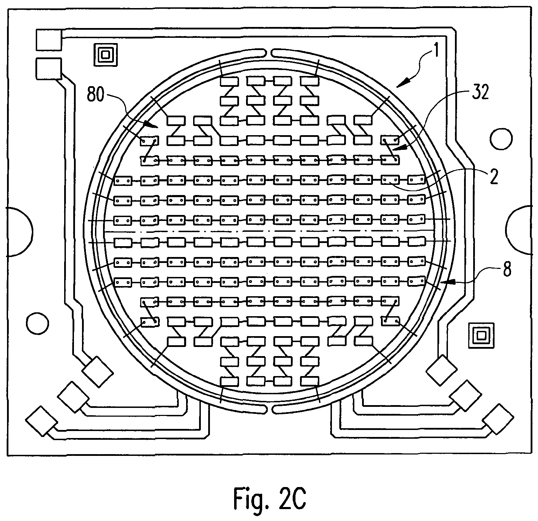

Erfindungsgemäß können mid- und/oder low-power (0.05-0.6 W) LED-Chips 2 innerhalb des Dammes 8 (im von dem Damm umgebenden Raum 80) montiert werden (zB. Siehe Fig. 2A-C). Anwendung von high-power LED-Chips 2 ist auch vorstellbar basierend auf den beschriebenen Beispielen. Die LED -Chips 2 sind vorzugsweise in Serien (in Strängen 32 strukturiert) geschaltet (Siehe Fig. 2A-C). Ein Strang 32 enthält bevorzugt von 5 bis 20 LED-Chips 2, mehr bevorzugt 10-14 LED-Chips 2, besonders bevorzugt 12 LED-Chips 2. Die LED-Chips 2 sind bevorzugt in 1-15 Strängen, mehr bevorzugt in 6-12 Strängen auf dem LED-Modul 1 eingerichtet, um die kürzeste elektrische Verbindungen zwischen LED-Chips 2 und die Bondpads 11 zu erzielen. Das LED-Modul 1 ist vorzugsweise mit von 40 bis 160 LED-Chips 2, besonders bevorzugt von 70 bis 150 LED-Chips 2 bspw. nach den Darstellungen Fig. 2A-C gleichmäßig und mit geringem Anstand zueinander bestückt, um eine möglichst homogene Lichtverteilung zu erzielen.

Alternativ kann das LED-Modul 1 nach einer weiteren Ausführungsform der Erfindung 10-50 LED-Chips 2 eingerichtet in 1-4 Strängen enthalten.

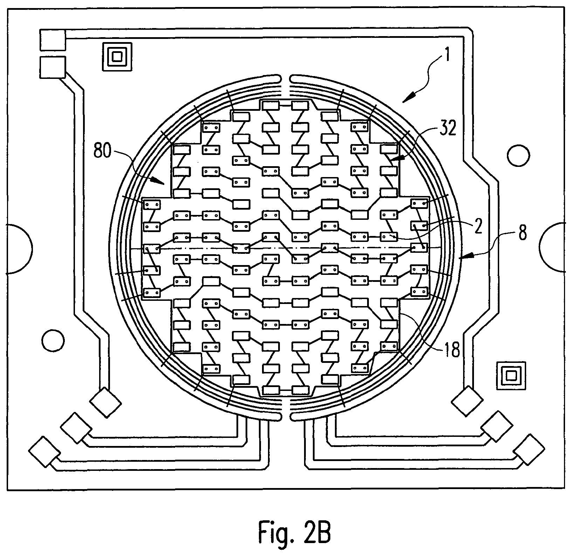

Die von den LED-Chips besetzte Oberfläche 18 (z.B. Siehe Fig. 2B) ist bspw. von 60% bis 90%, bevorzugt 64-75 % von der Gesamtoberfläche des Raumes 80.

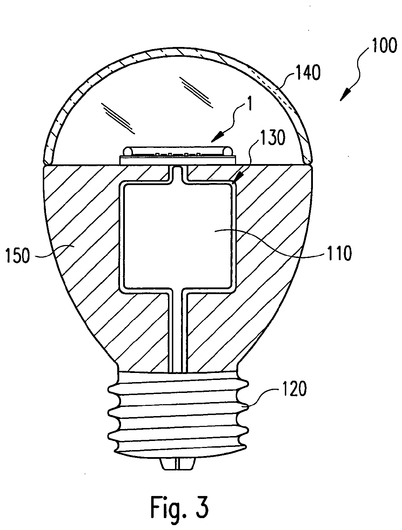

Die erwähnte Lösungen haben den Vorteil, daß bei einer Anwendung des LED-Moduls 1 mit einem optischen Element(en) (z.B. Reflektor 15, siehe Fig. 4) und /oder in einer Leuchte (z.B. Downlight, Spotlight, LED-Bulb, siehe Fig. 3) die durch die gleichmäßige Bestückung der LED-Chips 2 erreichte homogene Lichtverteilung/lichtemittierende Fläche nicht unvorteilhaft umgeformt wird.

Erfindungsgemäß kann ein Spotlight oder eine Retrofit LED-Lampe 100 (siehe Figur 3) vorgesehen sein, welche wenigstens ein LED-Modul 1 gemäß der Erfindung aufweisen. Unter "Retrofit" Lampe werden Lampen verstanden, die hinsichtlich ihrer mechanischen und elektrischen Anschlüsse zum Ersatz bestehender Leuchtmittel (Glühbirne, Halogenlampe,...) ausgebildet sind. Sie kann also nach ihrem äußeren Erscheinungsbild im Wesentlichen die Form einer herkömmlichen Glühbirne oder Halogenlampe aufweisen und/oder mit einem entsprechenden (Lampen-)Sockel 120 (bspw. E27 oder E14) oder Stecker (nicht gezeigt) ausgestattet sein. Zur Anpassung des Versorgungsstroms weist die Retrofit LED-Lampe zudem üblicherweise eine eigene Treiberschaltung 110 auf, die ausgehend bspw. von einer über den Sockel 120 zugeführten Netzspannung den Versorgungsstrom an die Betriebsbedingungen der LEDs anpasst. Somit können die Retrofit LED-Lampen 100 wie konventionelle Lampen in gewöhnliche Fassungen eingeschraubt bzw. eingesetzt und mittels des zugeführten Netzstroms betrieben werden. Die Treiberschaltung 110 kann mechanisch und elektrisch geschützt in einem Treibergehäuse 130 als Teil eines Gehäuses angeordnet sein. Weiterhin kann die Retrofit LED-Lampe 100 eine transparente Abdeckung 140 als weiteren Teil des Gehäuses aufweisen, die einem Glaskolben einer herkömmlichen Glühbirne bzw. Halogenlampe nachgebildet ist. Beim Betrieb der LED-Lampe 100 wird durch das LED-Modul 1 und auch durch die Treiberschaltung 110 Wärme erzeugt. Diese Wärme wird in der Regel über einen thermisch mit dem LED-Modul 1 und der Treiberschaltung 110 verbundenen Kühlkörper 150 (als weiteren Teil des Gehäuses) abtransportiert. Neben den vorgenannten Merkmalen kann die LED Lampe 100 auch weitere elektrische, elektronische und/oder mechanische Bauteile aufweisen, wie bspw. einen Reflektor zum gezielten Abstrahlen des Lichts, eine Sensorik zum Messen und Steuern des LED-Moduls 1 sowie weitere bekannte Merkmale eines Vorschaltgerätes und/oder zur Abstrahlung und/oder Veränderung des Lichtes.

Für Spotlights ist die Geometrie des Dammes 8 in der Draufsicht vorzugsweise kreisförmig, wobei auch andere durch den Damm 8 definierte Geometrien möglich sind, wie beispielsweise Rechteckformen etc. Der Durchmesser des kreisförmigen Dammes beträgt vorzugsweise von 17 bis 28mm, mehr bevorzugt von 19 bis 26mm.

Im Folgenden wird ein Verfahren zur Herstellung eines erfindungsgemäßen LED-Moduls 1 beschrieben.

In einem ersten Schritt wird auf einen Träger 3 (bspw. Leiterplatte) eine metallische Schicht 4, vorzugsweise eine Silberschicht (oder Goldschicht) mit einer Stärke von ca. 30 bis 8000nm aufgebracht. Diese wird erfindungsgemäß mit einer weiteren (Schutz-) Schicht aus Oxiden versehen. Träger 3 und metallische Schicht 4 können auch aus einem Basissubstrat bestehend aus Aluminiumplatte mit aufgedampften Reinstaluminiumschichten und ggf. Schichten aus Oxiden bestehen, auf welche eine (FR4) Leiterplatte 31 auflaminiert wird, welche vorzugsweise Ausnehmungen aufweist, welche das Basissubstrat 13 wenigstens stellenweise freigeben, in die bzw. auf das dann später die LED-Chips 2 gesetzt werden können.

In einem zweiten Schritt wird auf den Träger 3 - genauer auf die metallische Schicht 4 des Trägers 3 - ein keramischer Lack ("ink") bspw. mittels eines Siebdruckverfahrens aufgebracht. Der keramische Lack wird derart vorgesehen, dass die metallische Schicht 4 des Trägers 3 von der entstehenden Lackschicht 5 wenigstens teilweise, vorzugsweise vollständig bedeckt ist. Es ist dabei denkbar, dass dieser Schritt mehrfach (beliebig oft) wiederholt wird, um die Schichtdicke des Lackes zu erhöhen. Bei einem einfachen Druckvorgang weist die Lackschicht 5 bspw. eine Stärke von ungefähr 15 bis 20µm auf. Durch eine mehrfache Bedruckung kann die Stärke der Lackschicht 5 erhöht werden auf einen Bereich von beispielsweise 40 bis 50µm oder mehr. Durch die Erhöhung der Lackdicke erhöht sich der Reflexionsgrad der Lackschicht 5 von beispielsweise 80% bei 18pm auf etwa 95% bei 40 bis 50µm. Dieser Reflexionsgrad gilt jeweils bei Messung der Lackschicht auf einem schwarzen Untergrund.

Das durch die Lackschicht 5 hindurchgehende Licht des LED-Chips 2 kann aufgrund der darunter liegenden metallischen Schicht bzw. Silberschicht 4 zurückreflektiert werden. Diese doppelt reflektive Ausgestaltung hat den Vorteil, dass beispielsweise bei einer oxidativen Schwärzung der Silberschicht 4 immer noch ein wesentlicher Anteil des Lichts durch die darüber liegende Lackschicht 5 reflektiert wird, was den Wirkungsgrad des Moduls 1 steigert. Auch kann die Lackschicht 5 als Oxidationsschutz für die metallische Schicht 4 dienen, so dass deren Reflexionseigenschaften während der Lebensdauer des Moduls 1 im Wesentlichen erhalten bleiben.

Die auf die metallische Schicht 4 aufgebrachte Lackschicht 5 wird erfindungsgemäß derart vorgesehen, dass die metallische Schicht 4 partiell von der Lackschicht 5 bedeckt ist. Partiell bedeutet in diesem Zusammenhang, dass die metallische Schicht 4 nicht gänzlich von der Lackschicht 5 bedeckt ist, sondern Freistellen 6 verbleiben, in die später die LED-Chips 2 eingesetzt und somit auf die metallische Schicht 4 aufgebracht werden. Bei einem Aufbau mit einer auf ein beschichtetes Basissubstrat auflaminierten (FR4) Leiterplatte decken sich die Ausnehmungen derselben bzw. die dadurch freigelegten Stellen des beschichteten Basissubstrats vorzugsweise wenigstens teilweise mit den Freistellen 6, in die die LED-Chips 2 vorzugsweise auf das beschichtete Basissubstrat und somit auf die metallische Schicht 4 aufgebracht werden können.

In einem dritten Schritt wird/werden sodann wenigstens ein oder mehrere LED-Chip(s) 2 (z.B. in Figur 1 vier LED-Chips 2) auf die metallische Schicht 4 in den Freistellen 6 der Lackschicht 5 platziert; also aufgebracht, und elektrisch kontaktiert. Vorzugsweise wird der LED-Chip 2 gemäß der Chip-on-Board (COB) Technologie oder auch als SMD LED befestigt. Die Bonddrähte 12 sind z.B. in Figur 2A-C gezeigt. Es ist jedoch auch, in Ausgestaltungen außerhalb der Erfindung, denkbar, dass die LED-Chips 2 auf die Lackschicht 5 aufgesetzt werden, sollte diese die gesamte metallische Schicht 4 bedecken. Auch kann der LED-Chip 2 direkt auf dem Träger 3 vorgesehen werden. In diesem Fall wird der LED-Chip 2 vorzugsweise zuerst auf den Träger 3 aufgebracht, so dass er nach dem Beschichten seitlich von der metallischen Schicht 4 sowie der Lackschicht 5 umgeben ist; in Abstrahlrichtung (also insbesondere auf seiner Oberseite 21) ist der LED-Chip 2 dann selbstverständlich nicht beschichtet.

Die LED-Chips 2 werden vorzugsweise geklebt, besonders vorzugsweise auf die metallische Schicht 4 oder Basissubstrat 13 geklebt. Hierzu kann vorteilhafterweise ein reflektierender, vorzugsweise weißer Kleber verwendet werden. Die Dosierung des Klebers sollte gemäß einer bevorzugten Ausgestaltung derart gewählt werden, dass beim Platzieren des LED-Chips 2 auf dem Kleber bspw. in den Freistellen 6 der Lackschicht 5 dieser seitlich derart verdrängt wird, sodass er eine möglicherweise verbleibende Lücke 7 zwischen der Seitenwand 20 des LED-Chips 2 und einer dem LED-Chip 2 zugewandten Randbegrenzung 50 der keramischen Lackschicht 5/ der Freistelle 6 (ggf. auch der metallischen Schicht 4) wenigstens teilweise oder vollständig ausfüllt, so dass die metallische Schicht 4 (und ggf. auch die auflaminierte (FR4) Leiterplatte) im letztgenannten Fall vollständig abgedeckt ist. Somit kann eine doppelt reflektive Ausgestaltung auch in LED-Chip 2 nahen Bereichen und über die gesamte Fläche des Moduls 1 bzw. Trägers 3 erzielt werden.

In einem optionalen vierten Schritt wird ein Damm 8 wenigstens teilweise auf der metallischen Schicht 4 (ggf. einschließlich einer eventuell vorhandenen auflaminierten (FR4) Leiterplatte) und/oder der Lackschicht 5 derart aufgebracht bzw. vorgesehen, dass der Damm 8 den oder die LED-Chips 2 seitlich umgibt. Der Damm 8 wird vorzugsweise als ringförmiger Damm (bspw. Torus) gebildet. Vorzugsweise wird der Damm 8 aus einem flüssigen Polymer bzw. Harz oder einer Polymermischung um die LED-Chips 2 herum auf der metallischen Schicht 4 aufgebracht. Alternativ kann der Damm 8 sich auch zumindest teilweise über die vorzugsweise gedruckte keramische Lackschicht 5 erstrecken.

Es ist festzuhalten, dass "Ring" oder "ringförmig" im Zusammenhang mit der vorliegenden Beschreibung und den Ansprüchen keine Beschränkung im Bezug auf die Kontur der Wände des Dammes 8 darstellt; z. B. muss der Ring nicht notwendigerweise eine kreisförmige Form haben, sondern kann z.B. die Form eines Quadrats, eines Ovales, einer Ellipse oder eines Rechtecks etc. haben. Die Kreisform ist wegen der Anwendungsnähe zu rund ausgestalteten Reflektoren bevorzugt, da die mehreren LEDs bevorzugt als ein einzelnes rundes optisches Element erscheinen. Eine quadratische Form ist aufgrund der einfacheren Anordnung fertigungstechnisch bevorzugt.

Vorzugsweise wird eine ebene Platte als Träger 3 ohne Vertiefungen verwendet, da der reflektierende Effekt von Wänden einer Vertiefung durch die Dammwände erreicht werden kann.

Dispenstechniken für Harze und Silikone und dergleichen sind als solche aus dem Stand der Technik bekannt. Die Querschnittsform des Dammes 8 kann durch den Durchmesser der verwendeten Dispensnadel, der Fließcharakteristik des flüssigen Damm-Materials und der Fluss-(Dispens-)Geschwindigkeit kontrolliert werden. Bedingt durch die Dispenstechnik kann bspw. der Querschnitt des Damms 8 zum Gipfel des Damms 8 hin eine zulaufende Form aufweisen. Dadurch ist die innere Fläche des Damms 8 abgeschrägt und vorzugsweise steiler an ihrem oberen Teil, was zu Reflexionszwecken vorteilhaft sein kann.

Der Damm 8 kann neben Dispensen auch mittels sog. Overmoulding hergestellt werden. Kann dieser dann nicht mehr zum Schutz der Wirebonds eingesetzt werden, erhöht die emittierende Oberfläche leicht. Alternativ kann der Damm 8 auch als vorgefertigtes Element bereitgestellt werden, welches vorzugsweise aus einem Polymer bzw. Harz, Keramik, Metall oder einem anderen Kunststoff, bspw. als Spritzgussteil, hergestellt ist.

In einem an den vierten Schritt sich anschließenden optionalen fünften Schritt des Herstellungsprozesses wird der von dem Damm 8 umgebende Raum mit einem Füllmaterial ausgefüllt. Mit anderen Worten wird das von den inneren Wänden des eigenstabilen Ringes 8 begrenzte Volumen mit einem flüssigen Füllmaterial gefüllt. Wie in Figur 1 zu sehen ist, ist diese zentrale Füllung 9 vorzugsweise so hergestellt, dass die Oberseite der Füllung 9 mit der Oberseite der Wände des Dammes 8 bündig abschließt. Besonders vorzugsweise wird die zentrale Füllung 9 derart vorgesehen, dass sie die Oberseite des LED-Chips 2 zur Gänze bedeckt bzw. beschichtet. Die zentrale Füllung 9 bedeckt ebenfalls den Raum zwischen dem LED-Chip 2 und den Wänden des Dammes 8 und berührt die Lackschicht 5 und, via Freistellen 6 im Lack die metallische Schicht (Silberschicht oder Reinstaluminiumschicht oder dergleichen) 4 oder den zum Aufbringen der LED-Chips 2 verwendeten Kleber. Aufgrund der bevorzugten Füllung mit einem flüssigen Polymer bzw. Harz wird die Oberseite der zentralen Füllung 9 vorzugsweise flach ausgebildet sein.

Vorzugsweise wird folglich flüssiges ungehärtetes Polymer bzw. Harz (z.B. Silikon) in einen von einem eigenstabilen Damm 8 aus ungehärtetem Polymer/Harz hergestellten Hohlraum gefüllt. Die Materialien des Dammes 8 und der zentralen Füllung 9 sind hierbei vorzugsweise ähnlich oder dieselben, so dass diese vorzugsweise chemisch identisch sind. Die chemische Identität sollte dergestalt sein, dass das für den Damm 8 und die zentrale Füllung 9 benutzte Material jeweils durch den Gebrauch desselben Härtungs-Mechanismus gehärtet werden kann, um vorzugsweise einen chemischen und/oder physischen Bond zwischen den beiden Materialien über deren Grenzfläche hinweg herzustellen.

In Bezug auf optische und mechanische Charakteristiken können die Materialien des Dammes 8 und der zentralen Füllung 9 unterschiedlich sein; so kann das mit dem Material der zentralen Füllung vorzugsweise identische Material des Dammes 8 auch mit unterschiedlichen 'Additiven' als das Material der zentralen Füllung 9 ausgestattet werden. Für gefärbte LED Module (z.B. blau, grün, amber und rot) ist es nicht notwendig, zusätzliche Füller zu dem Polymer bzw. Harz für die zentrale Füllung 9 hinzuzufügen. Auf der anderen Seite können für weiße Farbkonversions-LED-Module dem Füllmaterial der zentralen Füllung 9 Farbkonversionspartikel zugefügt werden. Der Typ und die Menge der Farbkonversionspartikel hängen von der gewünschten Farbtemperatur des LED-Moduls 1 ab, welche als solches aus dem Stand der Technik bekannt sind. Vorzugsweise gibt es einen zunehmenden Konzentrationsgradienten der Farbkonversionspartikel von oben nach unten, welcher z. B. durch Absinkenlassen der Farbkonversionspartikel auf den Boden der Füllung 9 erreicht werden kann.

Sind der Damm 8 sowie die zentrale Füllung 9 aus einem flüssigen Polymer bzw. Harz oder einer Polymermischung hergestellt, so wird dieser vorzugsweise nach dem Aufbringen bzw. Ausfüllen gehärtet. Der Schritt des Aufbringens des Dammes 8 sowie der des Ausfüllens des Dammes 8 mit dem Füllmaterial umfasst somit ferner vorzugsweise die Härtung des vorzugsweise aus einem flüssigen Polymer/Polymermischung hergestellten Dammes 8 bzw. die Härtung des vorzugsweise aus einem flüssigen Polymer/Polymermischung hergestellten Füllmaterials der zentralen Füllung 9. Das Härten des Dammes 8 und das Härten der zentralen Füllung 9 kann nach den jeweiligen Schritten zum Vorsehen des Dammes 8 und der zentralen Füllung 9 - also unabhängig voneinander - durchgeführt werden.

In einer besonders bevorzugten Ausführungsform können die flüssigen Polymer(mischungen), d.h. die Polymere bzw. Harze der zentralen Füllung 9 und des Dammes 8, durch einen einzelnen Härtungsvorgang gehärtet und somit vorzugsweise chemisch an ihrer Grenzfläche miteinander verbunden werden. Dieser Herstellungsprozess beruht auf einer vergleichsweise hohen mechanischen Stabilität des Materials der Wand des Dammes 8 im nicht gehärteten 'flüssigen' Zustand. Es können wiederum, um diese mechanische Stabilität in einem flüssigen Zustand zu erzielen, zusätzliche Füllmaterialien, wie zum Beispiel Silikone, dem Material des Dammes 8 beigefügt werden. Das gemeinsame Aushärten des Dammes 8 und der zentralen Füllung 9 hat folglich den Vorteil, dass eine Polymerisierung zwischen dem Dammmaterial und dem Matrixmaterial der zentralen Füllung 9 erfolgen kann.

Sowohl zur Herstellung des Dammes 8 als auch für die Füllung 9 kann eine standardisierte computergesteuerte Abgabeeinrichtung verwendet werden.

Die Erfindung ist nicht auf die zuvor beschriebenen Ausführungsbeispiele beschränkt, solange sie vom Gegenstand der folgenden Ansprüche umfasst ist.

So ist es denkbar, dass zunächst die LED-Chips 2 auf den Träger 3 aufgebracht werden und danach der Träger 3 (ausgenommen die LED-Chips 2) mit der metallischen Schicht 4 beschichtet und daran anschließend die Lackschicht 5 aufgebracht wird. Entscheidend ist lediglich, dass die Kombination aus Lackschicht 5 und metallischer Schicht 4 für das von dem LED-Chip 2 emittierte Licht eine doppelt reflektive Wirkung bildet, so dass das durch die Lackschicht 5 hindurchgehende Licht des LED-Chips 2 aufgrund der darunter liegenden metallischen (Silber-)Schicht 4 zurückreflektiert wird und somit der Wirkungsgrad des Moduls 1 gesteigert wird.

Auch kann das Modul 1 bspw. allgemein als elektronisches oder optoelektronisches Modul ausgebildet sein und anstelle eines LED-Chips andere elektronische oder optoelektronische Bauteile aufweisen.

Beispielsweise kann das Modul 1 als eine Licht-löschbare Speichervorrichtung ausgebildet sein, wie zum Beispiel ein EEPROM. Die Erfindung kann ebenfalls für lichtempfindliche Sensoren, wie zum Beispiel RGB-Sensoren, Infrarotsensoren oder CCD Sensoren verwendet werden. Infrarot-Emitter sowie lichtempfindliche Lichterfassungsvorrichtungen sind ebenfalls Anwendungsgebiete, im Besonderen wenn der Sensor als ein Nacktchip ("Bare Chip") in der COB- oder Trägerstreifentechnologie ("Lead Frame") vorhanden ist.

Die Beschichtung kann, übereinstimmend mit der vorliegenden Erfindung, auch im Zusammenhang mit Lichtführungen und optischen Fasern verwendet werden. Eine optische Faser, zu welcher Licht aus der Lichtquelle 2 übertragen werden soll, ist vorzugsweise beabstandet von und vor der Lichtquelle 2 angeordnet und erstreckt sich bspw. aus dem Füllmaterial 9 heraus von der Lichtquelle 2 weg. Ferner kann das Modul 1 mit einer mechanischen Befestigung für die optischen Fasern versehen sein. Eine derartige Anordnung sorgt für eine verbesserte Lichtübertragung von der Lichtquelle 2 zu der optischen Faser.

### Liste der Bezugszeichen

- 1: LED-Modul
- 2: LED-Chip
- 3: Träger
- 4: metallische Schicht
- 5: Lackschicht
- 50: Randbegrenzung der Lackschicht
- 6: Freistelle
- 7: Lücke
- 8: Damm
- 9: zentrale Füllung
- 10: von der Lackschicht unbedeckte Bereiche
- 11: Bondpad
- 12: Bonddraht
- 13: Basissubstrat
- 14: Ausnehmung
- 15: Reflektor
- 16: zusätzliches Substrat
- 17: Trägeroberfläche unter dem Damm
- 18: die von den LED-Chips besetzte Oberfläche
- 31: Leiterplatte
- 32: Strang der LED-Chips
- 20: Seitenwand des LED-Chips
- 21: Oberseite des LED-Chips
- 80: von dem Damm umgebender (nach Aussen abgegrenzter) Raum
- 90: Streupartikel

## Patentansprüche

1. LED-Modul (1), aufweisend:
- einen Träger (3) mit hohem Reflexionsgrad, wobei auf dem Träger (3) eine metallische Schicht (4), vorzugsweise eine Silberschicht oder eine Schicht aus Reinstaluminium, aufgebracht ist,
- eine Oxidschicht über der metallischen Schicht (4), und
- wobei über der metallischen Schicht und der Oxidschicht eine Lackschicht (5) vorgesehen ist,
- weiterhin aufweisend einen LED-Chip auf der metallischen Schicht,
- wobei die Lackschicht (5) Freistellen aufweist, in die die LED-Chips eingesetzt sind, um auf der metallischen Schicht (4) aufgebracht zu sein.

2. LED-Modul nach Anspruch 1, wobei die metallische Schicht aus einer bondbaren oder zumindest in Teilbereichen bondbaren Oberfläche besteht, und wobei diese in den nicht bondbaren Oberflächenbereichen zusätzlich durch Oxide oder organische Schicht(en) gegen Veränderung geschützt ist.

3. LED-Modul nach Anspruch 1 oder 2, wobei die metallische Schicht zusätzlich durch Oxide oder organische Schicht(en) gegen Veränderung geschützt ist.

4. LED-Modul nach einem der vorhergehenden Ansprüche, das derart ausgestaltet ist, dass wenigstens ein Teil von auf das Modul fallendem Licht, bspw. von einem auf dem Modul anbringbaren LED-Chip, durch die Metallschicht reflektiert wird.

5. LED-Modul (1) gemäß einem der vorhergehenden Ansprüche,
wobei die Lackschicht (5) teilweise auf der metallischen Schicht (4) aufgebracht ist.

6. LED-Modul (1) gemäß einem der vorhergehenden Ansprüche, wobei die Lackschicht (5) eine mittlere Dicke von 5 bis 250µm, bevorzugt 10 bis 100µm, vorzugsweise 20 bis 50µm aufweist.

7. LED-Modul (1) gemäß einem der vorhergehenden Ansprüche, wobei die metallische Schicht (4) eine Stärke von 30nm bis 8000nm, vorzugsweise eine Stärke von 100nm bis 300nm oder 2000nm bis 6000nm aufweist.

8. Spotlight oder Retrofit LED-Lampe aufweisend wenigstens ein LED-Modul (1) gemäß einem der vorhergehenden Ansprüche, vorzugsweise ferner aufweisend eines oder mehreres von:
- einem Gehäuse (130, 140, 150),
- einem Reflektor (15),
- einer Treiberschaltung (110),
- einer Sensorik,
- einem Kühlkörper (150) und/oder
- einem Lampensockel (120).

9. Verfahren zur Herstellung eines LED-Moduls mit einem Träger mit hohem Reflexionsgrad, wobei das Verfahren die folgenden Schritte aufweist:
- Aufbringen einer metallischen Schicht (4) auf einen Träger (3),
- Aufbringen eines keramischen Lacks auf den Träger (3) derart, dass die metallische Schicht (4) des Trägers (3) von einer Lackschicht (5) teilweise bedeckt ist und Freistellen aufweist,
- Platzieren von wenigstens einem LED-Chip (2) in die Freistellen, sodass der wenigstens eine LED-Chip (2) in die Freistellen eingesetzt ist, um auf der metallischen Schicht (4) aufgebracht zu sein.

10. Verfahren nach Anspruch 9, wobei das Verfahren ferner die Schritte aufweist, wobei mehrere Schritte zum Aufbringen des keramischen Lacks auf die metallische Schicht (4) vorgesehen sind, so dass die Schichtdicke der Lackschicht (5) erhöht wird.

11. Verfahren nach einem der Ansprüche 9 oder 10, wobei der LED-Chip (2) in den Freistellen (6) der Lackschicht (5) auf die metallische Schicht (4) geklebt wird, vorzugsweise mit einem reflektierenden, besonders vorzugsweise weißen Kleber, und wobei die Dosierung des Klebers vorzugsweise derart gewählt wird, dass beim Platzieren des LED-Chips (2) auf den Kleber in den Freistellen (6) der Kleber seitlich derart verdrängt wird, sodass er die verbleibende Lücke (7) zwischen der Seitenwand (20) des LED-Chips (2) und einer dem LED-Chip (2) zugewandten Randbegrenzung (50) der keramischen Lackschicht (5) wenigstens teilweise oder vollständig ausfüllt, so dass die metallische Schicht (4) im letztgenannten Fall vollständig abgedeckt ist.

## Claims

1. LED module (1) comprising:
- a carrier (3) with a high degree of reflection, wherein a metallic layer (4), preferably a silver layer or a layer made of ultrapure aluminum, is applied to the carrier (3),
- an oxide layer over the metallic layer (4), and
- wherein a lacquer layer (5) is provided over the metallic layer and the oxide layer,
- further comprising an LED chip on the metallic layer,
- wherein the lacquer layer (5) comprises free spaces into which the LED chips are inserted in order to be applied to the metallic layer (4).

2. LED module according to Claim 1, wherein the metallic layer consists of a bondable surface or a surface that is bondable at least in sections, and wherein this metallic layer is additionally protected against change in the non-bondable surface areas by oxides or organic layer(s).

3. LED module according to Claim 1 or 2, wherein the metallic layer is additionally protected against change by oxides or organic layer(s).

4. LED module according to one of the preceding claims, which is designed in such a way that at least part of the light falling on the module, e.g., from an LED chip that can be mounted on the module, is reflected by the metal layer.

5. LED module (1) according to one of the preceding claims, wherein the lacquer layer (5) is partially applied to the metallic layer (4).

6. LED module (1) according to one of the preceding claims, wherein the lacquer layer (5) has a mean thickness of 5 to 250 µm, particularly 10 to 100 µm, preferably 20 to 50 µm.

7. LED module (1) according to one of the preceding claims, wherein the metallic layer (4) shows a strength of 30 nm to 8000 nm, preferably a strength of 100 nm to 300 nm or 2000 nm to 6000 nm.

8. Spotlight or retrofit LED lamp comprising at least one LED module (1) according to one of the preceding claims, preferably further comprising one or more:
- housings (130,140,150),
- reflectors (15),
- driver circuits (110),
- sensor systems,
- cooling bodies (150), and/or
- lamp bases (120).

9. Method for producing an LED module comprising a carrier with a high degree of reflection, wherein the method comprises the following steps:
- applying a metallic layer (4) to a carrier (3),
- applying a ceramic lacquer to the carrier (3) such that the metallic layer (4) of the carrier (3) is partially covered by a lacquer layer (5) and has free spaces,
- placing at least one LED chip (2) into the free spaces so that the at least one LED chip (2) is inserted into the free spaces in order to be applied to the metallic layer (4) .

10. Method according to Claim 9, wherein the method further comprises the steps, wherein several steps for applying the ceramic lacquer to the metallic layer (4) are provided so that the layer thickness of the lacquer layer (5) is increased.

11. Method according to one of Claims 9 to 10,
wherein the LED chip (2) in the free spaces (6) of the lacquer layer (5) is glued onto the metallic layer (4), preferably with a reflective, particularly preferably white, adhesive, and wherein the dosing of the adhesive is preferably selected in such a way that when placing the LED chip (2) onto the adhesive in the free spaces (6), the adhesive is displaced laterally such that it at least partially or completely fills the remaining gap (7) between the lateral wall (20) of the LED chip (2) and an edge border (50) of the ceramic lacquer layer (5) facing the LED chip (2) so that the metallic layer (4) is completely covered in the last-mentioned case.

## Revendications

1. Module LED (1), comprenant :
- un support (3) ayant une réflectivité élevée, une couche métallique (4), de préférence une couche d'argent ou en couche en aluminium extra-pur, étant appliquée sur le support (3),
- une couche d'oxyde étant appliquée sur la couche métallique (4), et
- une couche de vernis (5) étant prévue sur la couche métallique et la couche d'oxyde,
- comprenant en outre une puce LED sur la couche métallique,
- la couche de vernis (5) comprenant des zones libres, dans lesquelles les puces LED sont insérées pour être disposées sur la couche métallique (4).

2. Module LED selon la revendication 1, dans lequel la couche métallique se compose d'une surface pouvant être liée ou au moins liée par sections, et dans lequel celle-ci est protégée en outre par des couches d'oxydes ou organiques contre toute modification dans les zones de surface ne pouvant pas être liées.

3. Module LED selon la revendication 1 ou 2, dans lequel la couche métallique est protégée en outre par des couches organiques ou d'oxydes contre toute modification.

4. Module LED selon l'une quelconque des revendications précédentes, lequel est réalisé de telle façon qu'au moins une partie de la lumière incidente sur le module ou générée par la puce LED pouvant être disposée sur le module soit réfléchie par la couche métallique.

5. Module LED (1) selon l'une quelconque des revendications précédentes,
dans lequel la couche de vernis (5) est appliquée partiellement sur la couche métallique (4).

6. Module LED (1) selon l'une quelconque des revendications précédentes, dans lequel la couche de vernis (5) comprend une épaisseur moyenne de 5 à 250 µm, de préférence de 10 à 100 µm, plus préférablement de 20 à 50 µm.

7. Module LED (1) selon l'une quelconque des revendications précédentes, dans lequel la couche métallique (4) comprend une épaisseur de 30 nm à 8000 nm, de préférence une épaisseur de 100 nm à 300 nm ou de 2000 nm à 6000 nm.

8. Projecteur ou lampe LED de substitution comprenant au moins un module LED (1) selon l'une quelconque des revendications précédentes, de préférence comprenant en outre un ou plusieurs parmi :
- un boîtier (130, 140, 150),
- un réflecteur (15),
- un circuit de pilotage (110),
- un système de capteurs,
- un dissipateur de chaleur (150) et/ou
- un culot de lampe (120).

9. Procédé pour la fabrication d'un module LED comprenant un support ayant une réflectivité élevée, le procédé comprenant les étapes suivantes :
- application d'une couche métallique (4) sur le support (3),
- application d'un vernis céramique sur le support (3) de telle façon que la couche métallique (4) du support (3) soit partiellement recouverte d'une couche de vernis (5) et comprenne des zones libres,
- placement d'au moins une puce LED (2) dans les zones libres, de telle sorte que l'au moins une puce LED (2) soit insérée dans les zones libres pour être disposée sur la couche métallique (4).

10. Procédé selon la revendication 9, dans lequel le procédé comprend en outre les étapes dans lesquelles plusieurs étapes sont prévues pour l'application du vernis céramique sur la couche métallique (4), de telle sorte que l'épaisseur de couche de la couche de vernis (5) soit accrue.

11. Procédé selon l'une quelconque des revendications 9 à 10, dans lequel la puce LED (2) est collée sur la couche métallique (4) dans les zones libres (6) de la couche de vernis (5), de préférence au moyen d'une colle réfléchissante, particulièrement préférablement une colle blanche, et dans lequel le dosage de la colle est choisi de préférence de telle façon que lors du placement de la puce LED (2) sur la colle dans les zones libres (6) la colle est déplacée de telle façon qu'elle remplit l'espace (7) entre la paroi latérale (20) de la puce LED (2) et une des délimitations de bord (50) de la couche de vernis (5) faisant face à la puce LED (2) au moins partiellement ou complètement, de telle sorte que la couche métallique (4) soit complètement recouverte dans le dernier cas cité.
